# EUROPÄISCHE PATENTSCHRIFT

(11) **EP 2 831 304 B1**
(45) Veröffentlichungstag und Bekanntmachung des Hinweises auf die Patenterteilung: **08.08.2018**
(21) Anmeldenummer: 13713404.5
(22) Anmeldetag: 25.03.2013
(51) Int. Cl.: C23C 4/10, C23C 4/12, C23C 8/36

(54) **VERFAHREN ZUM PASSIVIEREN EINER METALLOBERFLÄCHE**
METAL SURFACE PASSIVATION METHOD
PROCÉDÉ DE PASSIVATION D'UNE SURFACE MÉTALLIQUE

(30) Priorität: 29.03.2012 DE 102012102721
(43) Veröffentlichungstag der Anmeldung: 04.02.2015
(73) Patentinhaber: PlasmaTreat GmbH, 33803 Steinhagen (DE)
(72) Erfinder: BUSKE, Christian, 33619 Bielefeld (DE); ARTAL LAHOZ, Maria Carmen, E-50007 Zaragoza (ES); ESCARTIN BARDUZAL, Andres, E-50009 Zaragoza (ES); ESTER SOLA, Francisco Javier, E-50001 Zaragoza (ES); MARCO LOSTAO, Francisco Javier, E-50162 Zaragoza (ES); MARTINEZ SOLANAS, Elena, E-50015 Zaragoza (ES); PENA TORRE, José Ignacio, E-50004 Zaragoza (ES); PLANAS LAYUNTA, Fernando, E-50009 Zaragoza (ES)
(74) Vertreter: Cohausz & Florack
(86) Internationale Anmeldenummer: PCT/EP2013/056220
(87) Internationale Veröffentlichungsnummer: WO 2013/144065

(56) Entgegenhaltungen:
- EP-A2- 0 653 502
- EP-A2- 2 194 162
- EP-A2- 2 460 595
- WO-A1-2010/112914
- FR-A- 853 144
- US-A- 5 858 465
- US-A1- 2009 061 184

## Beschreibung

Die vorliegende Erfindung betrifft ein Verfahren zum Passivieren einer Metalloberfläche, bei dem ein Passivierungsmittel auf die Metalloberfläche aufgebracht wird.

Unter einer Passivierung einer Metalloberfläche wird im Rahmen dieser Beschreibung beispielsweise das Aufbringen eines Korrosionsschutzmittels verstanden. Eine Passivierung kann auch das Aufbringen eines Mittels zum Verringern der Reibung bei der Verarbeitung eines Metallwerkstückes umfassen. Ebenso kann die Passivierung der Metalloberfläche auch das Verringern des elektrischen Widerstandes bedeuten, also eine elektrische Isolation der Metalloberfläche.

Ein Beispiel einer Passivierung einer Metalloberfläche ist die Phosphatierung, bei der durch chemische Reaktionen von metallischen Oberflächen mit wässrigen Phosphatlösungen eine sogenannte Konversionsschicht aus fest haftenden Metallphosphaten gebildet wird. Die Phosphatierung wird meist bei Stahl angewandt, kann aber auch für verzinkte oder cadmierte Stähle und Aluminium verwendet werden. Hauptanwendungsbereiche sind Korrosionsschutz, Haftvermittlung, Reib- und Verschleißminderung sowie elektrische Isolation.

Bei der aus dem Stand der Technik bekannten Phosphatierung erfolgt die Schichtbildung durch Ausfällung schwerlöslicher Phosphorsäuresalze, sogenannte Phosphate aus einer wässrigen Lösung. Je nach Art der Lösung kann es sich dabei um Eisen-, Zink-, oder Manganphosphatschichten handeln.

Bei der nichtschichtbildenden Phosphatierung stammen die an der Schichtbildung beteiligten Metallkationen aus dem Grundwerkstoff, die Metallkationen aus der Phosphatlösung sind nicht am Schichtaufbau beteiligt.

Bei der schichtbildenden Phosphatierung erfolgt der Schichtaufbau durch Metallkationen aus der Phosphatlösung, zusätzlich können Metallkationen aus dem Grundwerkstoff beteiligt sein. Die Schichtdicken reichen von einigen hundert Nanometern bei der Eisenphophatierung bis zu zwei Mikrometern und mehr bei Zink- und Manganphospatierungen.

Die so hergestellte Phosphatschicht haftet sehr gut auf dem Untergrund und erlaubt durch die mikroporöse beziehungsweise mikrokapillare Schichtstruktur eine gute Verankerung für nachfolgend aufzubringende Beschichtungen. Zusätzlich erschwert die Phosphatschicht die Unterrostung an schadhaften Stellen der Beschichtung. Phosphatschichten alleine bieten einen brauchbaren temporären Korrosionsschutz, der für das Lagern vor einem nachfolgenden Verarbeitungsschritt oft ausreicht. Ebenso sind Anwendungen bekannt, bei denen eine Phosphatierung zu einem dauerhaften Korrosionsschutz eingesetzt wird.

Die Phosphatschichten haben darüber hinaus gute Gleiteigenschaften. Dies wirkt sich vorteilhaft beispielsweise bei der Kaltumformung von Stahl aus. Hier werden aufgrund der leichten Abscherbarkeit Zinkphosphatschichten bevorzugt eingesetzt. Manganphosphatschichten werden dagegen zur Verschleißminderung von hochbelasteten Gleitpartnern verwendet.

Der hohe elektrische Widerstand von Phosphatschichten wird für eine zumindest teilweise elektrische Isolierung eingesetzt. Beispielsweise kann bei Elektroblechen für Magnetkerne die Phosphatschicht eingesetzt werden, um sie mit einer dünnen Trennschicht gegeneinander zu isolieren.

Des Weiteren ist ein Verfahren zum Passivieren einer Metalloberfläche bekannt, bei dem auf metallischen Oberflächen durch die Einwirkung von Chromsäure komplexe Chromsäuresalze (Chromate) gebildet werden. Ein solches Verfahren wird als Chromatierung bezeichnet.

Auch bei der Chromatierung wird der Grundwerkstoff der Metalloberfläche angelöst. Die gelösten Metallionen des Grundwerkstoffs werden dann in die Chromatschicht eingebaut. Die so erhaltenen Chromatschichten zählen - ähnlich den Phosphatschichten - zu den Passivierungsschichten, d.h. sie sind anorganische nichtmetallische Schutzschichten.

Die häufigste Funktion von Chromatschichten ist der Korrosionsschutz. Chromatschichten können aber auch zur Erzeugung eines Haftgrundes für nachfolgende Schichten, als Anlaufschutz (bei Silber), zur Verringerung der Sichtbarkeit von Fingerabdrücken oder zur Veränderung des Aussehens (Glanz, Farbe) eingesetzt werden. Chromatierungsverfahren können auf Aluminium, Magnesium, Silber, Cadmium und Zink angewendet werden.

All den zuvor beschriebenen Verfahren ist gemein, dass diese nur nasschemisch in einer Mehrzahl von Arbeitsschritten mittels Tauchbädern durchgeführt werden können. Daher ist der apparative Aufwand bei der Durchführung der Verfahren erheblich. Ebenso ist der Materialaufwand groß, weil ein großer Anteil des verwendeten Passivierungsmittels nicht zum Einsatz kommt.

Zudem können abgrenzbare Oberflächenbereiche eines Werkstückes nicht gesondert behandelt werden, sondern das gesamte Werkstück muss immer nasschemisch behandelt werden.

Dieses Problem stellt sich insbesondere bei der Herstellung von Bauteilen, die aus nichtkorrodierenden Metallblechen, beispielsweise aus Edelstahlblechen, bestehen und deren Einzelteile mittels Verschweißen miteinander verbunden werden. Die dabei entstehenden Schweißnähte sind nicht in gleicher Weise korrosionsbeständig wie das Metallblech selbst. Daher ist ein gesonderter Korrosionsschutz als Passivierungsmaßnahme allein für den Bereich der Schweißnaht erforderlich. Bei nasschemischer Passivierung, also beispielsweise einer Phosphatierung ist es dann erforderlich, das gesamte Bauteil nasschemisch zu behandeln.

Als Bauteile können hier exemplarisch Waschmaschinenbauteile, Geschirrmaschinenbauteile, Rohrverbindungen und andere während der Benutzung mit Wasser in Berührung kommende Bauteile genannt werden.

Des Weiteren ist gerade bei kleineren Bauteilen eine nasschemische Behandlung mit einem säurehaltigen Passivierungsmittel aufwändig, wenn diese für eine Farb- oder Lackbeschichtung als Grundierung eingesetzt werden soll. Zudem tritt bei der nasschemischen Behandlung gerade bei kleineren Bauteilstrukturen das Problem auf, dass wegen Oberflächenspannungseffekten Vertiefungen oder Hinterschneidungen nicht vollflächig mit dem Passivierungsmittel beaufschlagt werden. Daher entstehen hier Lücken auf der Oberfläche auf, die sich nachteilig beim späteren Einsatz des Bauteils auswirken können. Weiter offenbart EP 0 653 502 A2 ein Plasmaspritzverfahren, bei dem eine zinkphosphathaltige Abdeckschicht auf einem Stahlwerkstück aufgebracht wird.

Der vorliegenden Erfindung liegt daher das technische Problem zugrunde, das aus dem Stand der Technik bekannte Verfahren zum Passivieren einer Metalloberfläche zu vereinfachen und effektiver auszugestalten.

Das zuvor aufgezeigte technische Problem wird erfindungsgemäß durch ein Verfahren gelöst, bei dem ein atmosphärischer Plasmastrahl durch elektrische Entladung in einem Arbeitsgas erzeugt wird, bei dem ein säurehaltiges Passivierungsmittel in den Plasmastrahl eingebracht wird, bei dem der das Passivierungsmittel beinhaltende Plasmastrahl auf die Metalloberfläche aufgebracht wird und bei dem durch die Reaktion des säurehaltigen Passivierungsmittels mit der Metalloberfläche ein passivierendes Salz auf der Metalloberfläche abgeschieden wird.

Erfindungsgemäß ist also erkannt worden, dass das Aufbringen des Passivierungsmittels mittels eines atmosphärischen Plasmastrahls viele Synergieeffekte ausnutzt. Bevor diese erläutert werden, sollen zunächst Plasmaquellen und die Eigenschaften von damit erzeugten atmosphärischen Plasmastrahlen erläutert werden.

Unter einer Plasmaquelle wird eine Quelle für einen in einen Raumbereich hinein gerichteten Plasmastrahl verstanden, wobei die Form des Plasmastrahls rund oder flächig ausgebildet sein kann. Die Plasmaquelle kann auch einen rotierenden Plasmastrahl erzeugen, indem ein Gehäuseteil, vorzugsweise die Auslassöffnung drehbeweglich ausgebildet ist und sich während der Plasmaerzeugung um eine Achse dreht. Während des Verfahrens dieser Plasmaquelle längs einer Oberfläche wird dann ein breiter Streifen breiterer Streifen behandelt.

Die Plasmaquelle kann eine Plasmadüse oder mehrere nebeneinander angeordnete Plasmadüsen in Form einer Plasmadusche aufweisen. Die Plasmaquelle kann eine Halterung für eine Positionierung an der Bewegungseinrichtung und Zuführungen für Arbeitsgas und elektrischer Spannung aufweisen.

Die elektrische Anregung des Arbeitsgases kann mit unterschiedlichen Frequenzen, beispielweise im Mikrowellenbereich im Bereich von oder oberhalb von 1 MHz oder im Frequenzbereich von 1 bis 100 kHz erfolgen. Die Spannungsformen können zwischen Wechselspannungen und gepulsten Gleichspannungen variieren oder Überlagerungen derselben sein. Die Entladungen sind Mikrowellenentladungen oder hochfrequente Funkenentladungen, die die Form von Entladungsbögen (Bogenentladungen) oder Büschelentladungen aufweisen können. Die Spannungsamplituden sind, ebenso wie die Frequenz, an die jeweilige Geometrie der Plasmadüse angepasst und liegen beispielsweise im Bereich 100 Volt bis 10 kVolt. Als Arbeitsgas wird bevorzugt Luft eingesetzt, daneben sind auch Stickstoff, Edelgase wie Argon, auch unter Beimischung anderer Gase wie Wasserstoff möglich.

Derartige Plasmaquellen können verhältnismäßig kalte Plasmastrahlen mit relativ hoher chemischer Anregungsenergie erzeugen. Die Strahltemperatur fällt in Abhängigkeit vom Abstand zur Auslassöffnung ab und liegt im Bereich unterhalb von 300° C, vorzugsweise unterhalb von 150°C und bevorzugt unterhalb von 100°C. Die hohe Anregungsenergie des Arbeitsgases ergibt sich durch die hochfrequente Anregung in der Anregungszone innerhalb der Plasmaquelle, bei der nur eine geringe thermische Anregung erfolgt. Man spricht daher auch von einem nicht-thermischen Plasma. Durch die Wahl eines geeigneten Arbeitsgases und der Parameter der elektrischen Spannung kann die Temperatur und Aktivität des Plasmastrahls beeinflusst werden.

Das vorliegende Verfahren ist nicht auf die Verwendung von zuvor beschriebenen Plasmaquellen beschränkt. Auch andere Plasmaquellen, bspw. mit anderen Anregungsmechanismen, können zur Anwendung kommen, selbst wenn deren Plasmastrahlen andere Temperaturen und niedrigere Plasmaleistungen aufweisen. Auch bei derartigen bekannten Plasmaquellen kann das erfindungsgemäße Verfahren durchgeführt werden.

Ein Verfahren zur Erzeugung eines atmosphärischen Plasmastrahls, d.h. eines Plasmastrahls mit einem Umgebungsdruck, der in der Größenordnung des Atmosphärendrucks liegt, ist beispielsweise aus EP 1 335 641 A1 bekannt. Hier wird ein Arbeitsgas, vor allem Luft, Stickstoff, Formiergas (Mischung aus Stickstoff und Wasserstoff) oder ein Edelgas, insbesondere Argon oder Helium, durch einen Kanal geleitet, in dem durch eine hochfrequente Hochspannung ein Plasmastrahl über eine elektrische Entladung, d.h. eine Koronaentladung und/oder eine Bogenentladung, erzeugt wird.

Ein Verfahren zur Plasmapolymerisation mittels eines atmosphärischen Plasmastrahles wird in EP 1 230 414 B1 offenbart. Bei dieser Methode wird ein Precursormaterial in den Plasmastrahl eingebracht, dort chemisch und/oder elektronisch angeregt, so dass vor, bei oder nach der Abscheidung des angeregten Precursors auf eine Oberfläche eine Polymerisation des Precursors einsetzt.

Erfindungsgemäß wird nun das säurehaltige Passivierungsmittel mittels eines atmosphärischen Plasmastrahls auf die zu passivierende Metalloberfläche aufgebracht, wobei durch die Reaktion des säurehaltigen Passivierungsmittels mit der Metalloberfläche ein passivierendes Salz auf der Metalloberfläche abgeschieden wird. Dadurch werden mehrere Vorteile erreicht.

Zum einen wird durch die Zuführung des Passivierungsmittels in den Plasmastrahl die im Plasmastrahl enthaltene Anregungsenergie auf das Passivierungsmittel übertragen, ohne dabei eine große Temperaturerhöhung des Passivierungsmittels zu bewirken.

Zum anderen wird das Passivierungsmittel durch die oftmals bereits rotierende Strömung im Plasmastrahl gleichmäßig verwirbelt und somit beim Auftreffen auf der Metalloberfläche gleichmäßig verteilt. Die somit entstehende Verwirbelung führt zu einer nahezu vollständigen Benetzung der Oberfläche auch in Vertiefungen und Hinterschneidungen, auch wenn diese kleine Abmessungen aufweisen. Die Verwirbelung des Plasmastrahls und des darin transportierten Passivierungsmittels führt zudem dazu, dass nicht auf der Oberfläche verbleibendes Passivierungsmittel gleich wieder abtransportiert wird und keine Nachbearbeitung oder Reinigung notwendig ist.

Darüber hinaus bewirkt die Anwendung des Plasmastrahls auf der Oberfläche einen Reinigungseffekt, so dass bei nicht zu stark verschmutzten Oberflächen keine Vorreinigung erfolgen muss, bevor das Passivierungsmittel aufgebracht wird. Nur bei stärker verschmutzten Oberflächen, die nicht ausreichend durch den Plasmastrahl gereinigt werden können, ist eine separate Vorreinigung erforderlich. Die Anzahl der Arbeitsschritte ist also im Vergleich zum nasschemischen Verfahren deutlich reduziert und in einer Vielzahl von Anwendung reicht ein Verfahrensschritt für die Passivierung der Metalloberfläche aus.

Ein weiterer Vorteil besteht darin, dass durch die Beaufschlagung der Metalloberfläche mittels des Plasmastrahls keine Verschmutzung der Metalloberfläche auftritt, wie beispielsweise beim aus dem Stand der Technik bekannten nasschemischen Verfahren durch vorhergehende Tauchbäder oder Ähnliches.

Im Rahmen der Erfindung hat sich also überraschender Weise gezeigt, dass das Aufbringen eines Passivierungsmittels mittels eines atmosphärischen Plasmastrahls auf eine Metalloberfläche eine effektive Alternative zu dem bekannten nasschemischen Verfahren darstellt.

In bevorzugter Weise kann einerseits als Passivierungsmittel eine wässrige Phosphorsäure eingesetzt und Metallphosphat auf der Metalloberfläche abgeschieden werden. Andererseits kann als Passivierungsmittel eine Chromsäure eingesetzt und Metallchromat auf der Metalloberfläche abgeschieden werden. In beiden Fällen kommt es zu der oben beschriebenen Verbindung zwischen Säureanionen und Metallkationen und zur Ausbildung des jeweiligen Metallsalzes als Phosphat bzw. als Chromat.

Bei diesem Verfahren kommen hauptsächlich zwei positive Effekte zusammen.

Zum einen wird das Säureanion der Phosphorsäure bzw. der Chromsäure durch den Plasmastrahl selber angeregt und in einen reaktiven Zustand versetzt, ohne dass dabei eine zu stark erhöhte Temperatur des Säureanteils des Plasmastrahls zu induzieren. Zum anderen wird die Metalloberfläche selbst durch den Plasmastrahl aktiviert, wodurch die Reaktivität der Metalloberfläche erhöht wird und die erforderlichen Metallkationen während der chemischen Reaktion mit den Säurenanionen leichter erzeugt werden. Somit kommt es im Auftreffbereich des Plasmastrahls auf der Metalloberfläche zu der gewünschten Reaktion und Abscheidung des Metallsalzes.

Die Reaktivität der Säureanionen kann insbesondere auch durch eine entsprechende Veränderung der Parameter der Plasmaerzeugung eingestellt werden. Durch eine geeignete Wahl an Parametern kann die Behandlungszeit durch den Plasmastrahl verringert werden. Die so erzielten Behandlungszeiten liegen deutlich unterhalb der bei nasschemischen Verfahren erforderlichen Behandlungszeiten.

Das dem Plasmastrahl zugeführte säurehaltige Passivierungsmittel, also die wässrige Säurelösung kann Metallionen aufweisen oder nicht. Eine Chromatierung kann man beispielsweise mit Schwefelsäure und Natriumchromat durchführen. Die dabei entstehende Chromsäure reagiert dann mit der Oberfläche. Bei Einsatz von Phosphorsäure als Passivierungsmittel enthält diese dagegen keine Metallionen. Die Reaktion der Säure mit der Oberfläche führt dann z .B. zu einem Metallchromat oder einem Metallphosphat.

Welche genauen chemischen und physikalischen Vorgänge bei der Beaufschlagung des Plasmastrahls mit einem Passivierungsmittel ablaufen, ist noch nicht im Detail festgestellt worden. Jedenfalls hat sich überraschender Weise herausgestellt, dass die durch die zuvor beschriebenen Verfahren beaufschlagten Metalloberflächen eine für eine industrielle Fertigung ausreichende Passivierung erfahren haben.

Der nachfolgend beschriebene Ansatz ist daher vorläufig. Beim erfindungsgemäßen Verfahren wird die Säure vor dem Aufbringen im Plasma angeregt und reagiert dadurch wesentlich schneller mit der Oberfläche. Auch die bereits beschriebene gleichzeitig stattfindende Reinigung und Aktivierung der Oberfläche wirkt sich positiv auf die Reaktionsgeschwindigkeit aus.

Die klassische nasschemische Chromatierung besteht gewöhnlich aus zwei wesentlichen Schritten. Zunächst wird die Oxidschicht (Aluminiumhydroxid) mit Natronlauge vollständig entfernt. Nach Spülen mit Wasser wird anschließend sofort chromatiert. Mit dem erfindungsgemäßen Verfahren unter Einsatz des Plasmas kann die Entfernung der Oxidschicht entfallen. Die weitere Passivierung des Materials erfolgt daher direkt auf der Oxidschicht.

Wie oben bereits ausgeführt worden ist, kann die Phosphatierung insbesondere auf Stahl und Edelstahl sowie auf verzinkten oder cadmierten Stählen und Aluminium durchgeführt werden. Dagegen kann die Chromatierung insbesondere auf Aluminium, Magnesium, Silber, Cadmium und Zink angewendet werden.

Ein weiterer Vorteil des zuvor beschriebenen Verfahrens liegt darin, dass die Anwendung der Passivierung, beispielsweise mittels Phosphatierung, gezielt auf bestimmte Oberflächenbereiche angewendet werden kann. Ein Beispiel stellen hier Schweißnähte zwischen aneinandergefügten Edelstahlblechen dar, die üblicherweise für Trommeln und Innenauskleidungen von Waschmaschinen oder Geschirrspülmaschinen verwendet werden. Da die Edelstahlbleche an sich bereits ausreichend gegen Korrosion geschützt sind, die Schweißnähte allerdings aufgrund der Gefügeänderungen innerhalb des Metalls nicht mehr ausreichend korrosionsbeständig sind, besteht an sich nur im Bereich der Schweißnähte die Notwendigkeit einer nachträglichen Passivierung. Somit wird in bevorzugter Weise das zuvor beschriebene Verfahren so durchgeführt, dass zumindest die Schweißnaht zwischen zwei Metalloberflächen mit dem Plasmastrahl beaufschlagt wird.

Vorzugsweise kann die Metalloberfläche während des Schweißens oder unmittelbar nach dem Schweißen mit dem Plasmastrahl beaufschlagt werden. In diesem Fall kann die noch in der Schweißnaht und dem angrenzenden Metall gespeicherte thermische Energie für eine erhöhte Reaktivität der Metalloberfläche und somit für eine erhöhte Effektivität der Passivierung ausgenutzt werden. Des Weiteren ist auch eine Anwendung des beschriebenen Verfahrens bei einer Schweißnaht im abgekühlten Zustand möglich.

Neben der räumlich begrenzten Anwendung des Plasmastrahls beispielsweise auf einer Schweißnaht kann das beschriebene Verfahren auch so durchgeführt werden, dass die Beaufschlagung der Metalloberfläche mit dem Passivierungsmittel zum Erzeugen einer Grundierung für einen anschließenden Farbauftrag oder Lackierung durchgeführt wird. In diesem Fall wird eine flächige, insbesondere vollflächige Behandlung der Metalloberfläche durchgeführt. Das nachfolgende Beschichten mit einer Farbe oder einem Lack führt dann zu einer guten Haftung und langlebigen Beschichtung. Für eine derartige Anwendung sind insbesondere die oben beschriebenen rotierenden Plasmadüsen geeignet.

Das Passivierungsmittel kann in verschiedener Weise dem Plasmastrahl zugeführt werden. Da die Erzeugung des Plasmastrahls aus einem Strom von Arbeitsgas unterschiedliche Raumbereiche ausgehend vom Entladungsbereich, durch den Düsenbereich und den freien Strahl außerhalb der Plasmaquelle durchläuft, kann das Passivierungsmittel in jedem dieser Raumbereiche dem Plasmastrahl zugeführt werden.

Somit kann in bevorzugter Weise das Passivierungsmittel im Entladungsbereich dem entstehenden Plasmastrahl zugeführt werden. In diesem Fall wird das Arbeitsgas zusammen mit dem Passivierungsmittel mittels der elektrischen Entladung angeregt. Die Einwirkung der Entladung auf das Passivierungsmittel ist somit sehr stark und es hängt von der Art des Passivierungsmittels ab, ob dieses für die direkte Einwirkung der Entladung geeignet ist.

Des Weiteren kann das Passivierungsmittel strömungsabwärts des Entladungsbereiches dem entstandenen Plasmastrahl zugeführt werden. Einerseits kann das Passivierungsmittel noch innerhalb der Plasmaquelle vor dem Austritt des Plasmastrahls aus der Plasmadüse in den Strom des Plasmastrahls eingebracht werden. Andererseits kann das Passivierungsmittel auch außerhalb der Plasmaquelle dem Plasmastrahl zugeführt werden. Im letzteren Fall kommt das Passivierungsmittel nicht oder nur kaum mit der Plasmaquelle selbst in Kontakt, so dass Einflüsse durch den Säureanteil auf die Teile der Plasmaquelle minimiert werden können.

Für eine bessere Verteilung des Passivierungsmittels kann dieses in vorteilhafter Weise mittels einer Zerstäuberdüse eingebracht werden. Damit wird bereits beim Hinzufügen des Passivierungsmittels zum Arbeitsgas bzw. des Plasmastrahls eine feine und gleichmäßige Verteilung erreicht, die sich positiv bis hin zur Beaufschlagung des Plasmastrahls auf der Metalloberfläche auswirkt. Das Passivierungsmittel kann aber auch in anderer Art dem Plasmastrahl hinzugefügt werden.

Die Erfindung wird im Folgenden anhand von Ausführungsbeispielen näher erläutert, wobei auf die beigefügte Zeichnung Bezug genommen wird. In der Zeichnung zeigen
- Fig. 1: ein erstes Ausführungsbeispiel einer erfindungsgemäßen Vorrichtung zur Passivierung einer Oberfläche, bei der ein Passivierungsmittel im Bereich der Düsenöffnung in den Plasmastrahl eingebracht wird,
- Fig. 2: ein zweites Ausführungsbeispiel einer erfindungsgemäßen Vorrichtung zur Passivierung einer Oberfläche, bei der ein Passivierungsmittel im Bereich des Entladungsvolumens in den Plasmastrahl eingebracht wird und
- Fig. 3: ein drittes Ausführungsbeispiel einer erfindungsgemäßen Vorrichtung zur Passivierung einer Oberfläche, bei der ein Passivierungsmittel im Bereich vor der Düsenöffnung in den Plasmastrahl eingebracht wird.

Im Folgenden wird die Durchführung des erfindungsgemäßen Verfahrens anhand von drei Ausführungsbeispielen erläutert, die sich dahingehend unterscheiden, in welchem Bereich der Plasmadüse das säurehaltige Passivierungsmittel zugeführt wird. Daher bezeichnen gleiche Bezugszeichen gleiche Elemente bei den verschiedenen Ausführungsformen.

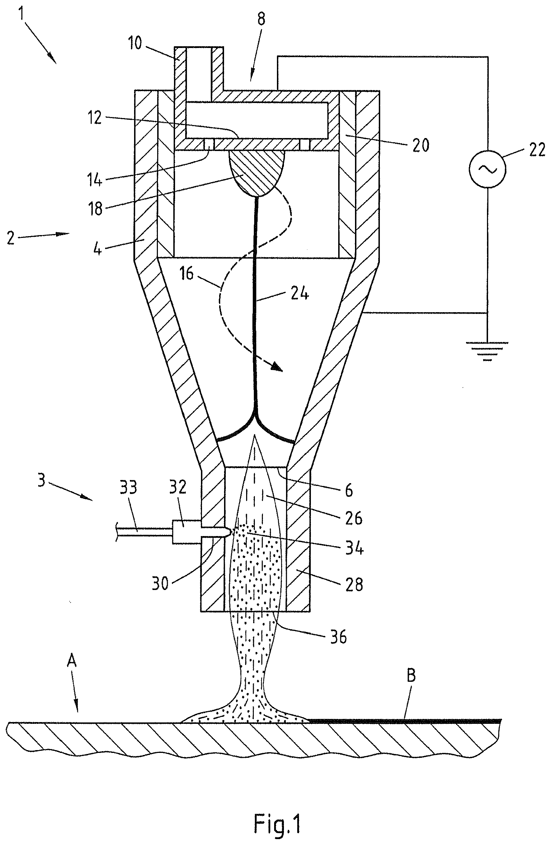

Fig. 1 zeigt eine Plasmaquelle 2 sowie eine Zuführvorrichtung 3 auf. Die Plasmaquelle 2 weist ein Düsenrohr 4 aus Metall auf, das sich konisch zu einer Düsenöffnung 6 verjüngt. Am der Düsenöffnung 6 entgegengesetzten Ende weist das Düsenrohr 4 eine Dralleinrichtung 8 mit einem Einlass 10 für ein Arbeitsgas auf, beispielsweise für Luft oder Stickstoffgas. Eine Zwischenwand 12 der Dralleinrichtung 8 weist einen Kranz von schräg in Umfangsrichtung angestellten Bohrungen 14 auf, durch die das Arbeitsgas verdrallt wird. Der stromabwärtige, konisch verjüngte Teil des Düsenrohres wird deshalb von dem Arbeitsgas in der Form eines Wirbels 16 durchströmt, dessen Kern auf der Längsachse des Düsenrohres 4 verläuft.

An der Unterseite der Zwischenwand 12 ist mittig eine Elektrode 18 angeordnet, die koaxial in Richtung des verjüngten Abschnittes in das Düsenrohr 4 hineinragt. Die Elektrode 18 ist elektrisch mit der Zwischenwand 12 und den übrigen Teilen der Dralleinrichtung 8 verbunden. Die Dralleinrichtung 8 ist durch ein Keramikrohr 20 elektrisch gegen das Düsenrohr 4 isoliert. Über die Dralleinrichtung 8 wird an die Elektrode 18 eine hochfrequente Hochspannung angelegt, die von einem Transformator 22 erzeugt wird. Der Einlass 10 ist über einen nicht gezeigten Schlauch mit einer unter Druck stehenden Arbeitsgasquelle mit variablem Durchsatz verbunden. Das Düsenrohr 4 ist geerdet. Durch die angelegte Spannung wird eine Hochfrequenzentladung in der Form eines Lichtbogens 24 zwischen der Elektrode 18 und dem Düsenrohr 4 erzeugt. Der Begriff "Lichtbogen" wird hier als phänomenologische Beschreibung der Entladung verwendet, da die Entladung in Form eines Lichtbogens auftritt. Der Begriff "Lichtbogen" wird auch als Entladungsform bei Gleichspannungsentladungen mit im Wesentlichen konstanten Spannungswerten verwendet.

Aufgrund der drallförmigen Strömung des Arbeitsgases wird dieser Lichtbogen im Wirbelkern auf der Achse des Düsenrohres 4 kanalisiert, so dass er sich erst im Bereich der Düsenöffnung 6 zur Wand des Düsenrohres 4 verzweigt. Das Arbeitsgas, das im Bereich des Wirbelkerns und damit in unmittelbarer Nähe des Lichtbogens 24 mit hoher Strömungsgeschwindigkeit rotiert, kommt mit dem Lichtbogen 24 in innige Berührung und wird dadurch zum Teil in den Plasmazustand überführt, so dass ein atmosphärischer Plasmastrahl 26 durch die Düsenöffnung 6 aus der Plasmaquelle 2 austritt.

Die Zuführvorrichtung 3 weist ein Mischrohr 28 auf, dessen Wand an einer Stelle eine Öffnung 30 aufweist, in die passgenau ein Zerstäuber 32 eingelassen ist. An den Zerstäuber 32 ist eine Zufuhr 33 für das Zuführen des Passivierungsmittels angeschlossen, durch die das Passivierungsmittel in den Zerstäuber 32 gelangt und dort zu einem feinen Nebel zerstäubt wird.

Das aus dem Zerstäuber 32 austretende Passivierungsmittel gelangt unmittelbar in den Plasmastrahl 26 und wird mit diesem in Richtung der Metalloberfläche A mitgerissen. Auf der Metalloberfläche A trifft dann das Passivierungsmittel in der oben beschriebenen Weise auf, so dass sich eine Passivierungsschicht B ausbildet. Wenn als Passivierungsmittel beispielsweise Phosphorsäure verwendet wird, dann bildet sich in der Passivierungsschicht B eine Metallphospatschicht aus.

Die Dicke der Passivierungsschicht kann unterschiedlich ausfallen und hängt von den Betriebsparametern ab. Unter anderem hängt die Dicke der Passivierungsschicht von der Menge des in den Plasmastrahl eingebrachten Passivierungsmittels ab. Im Fall von verdünnter Phosphatsäure hat sich ein Wert von ca. 50 g/h als Auftragungsrate als günstig herausgestellt.

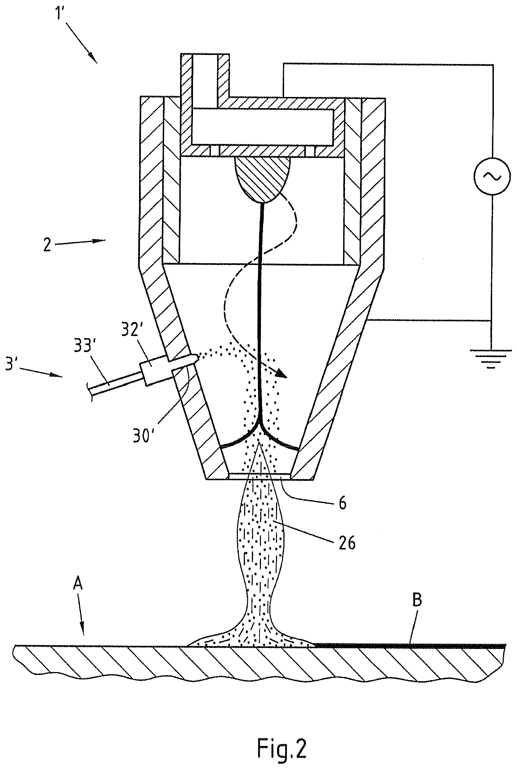

Fig. 2 zeigt ein zweites Ausführungsbeispiel einer Vorrichtung zur Passivierung einer Oberfläche. Die Vorrichtung weist eine zuvor anhand von Fig. 1 beschriebene Plasmaquelle 2 zum Erzeugen eines Plasmastrahls 26 auf sowie eine Zuführvorrichtung 3' mit einer Zerstäuberdüse 32' im konisch zulaufenden Bereich des Düsenrohres 10. In diesem Fall wird also das Passivierungsmittel in den Bereich der Plasmaquelle eingebracht, in dem die Bogenentladung gezündet und betrieben wird. Auch hier weist die Wand des Düsenrohres 10 an einer Stelle eine Öffnung 30' auf, in die passgenau der Zerstäuber 32' eingelassen ist. An den Zerstäuber 32' ist eine Zufuhr 33' für das Zuführen des Passivierungsmittels angeschlossen, durch die das Passivierungsmittel in den Zerstäuber 32' gelangt und dort zu einem feinen Nebel zerstäubt wird.

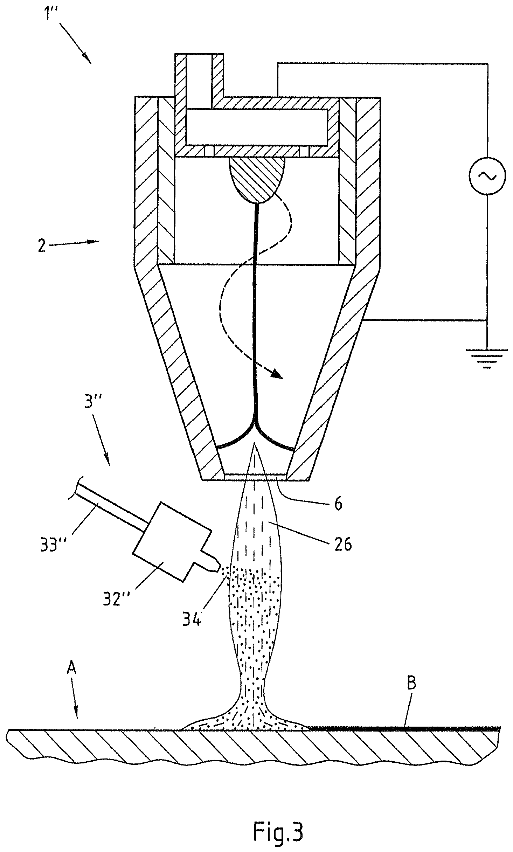

Fig. 3 zeigt ein drittes Ausführungsbeispiel einer Vorrichtung zur Plasma-Passivierung einer Metalloberfläche. Die Vorrichtung weist eine zuvor anhand von Fig. 1 und 2 beschriebene Plasmaquelle 2 zum Erzeugen eines Plasmastrahls 26 auf sowie einen stromabwärts der Düsenöffnung 6 angeordneten Zerstäuber 32". An den Zerstäuber 32" ist eine Zufuhr 33" angeschlossen, durch die das Passivierungsmittel in den Zerstäuber 32" gelangt und dort zerstäubt wird. Das aus dem Zerstäuber 32" austretende Passivierungsmittel gelangt in den in der Plasmaquelle 2 erzeugten und aus der Düsenöffnung 6 austretenden Plasmastrahl 26 und wird mit dem Plasmastrahl 26 weiter transportiert.

In den beschriebenen Figuren wird die Plasmaquelle jeweils von rechts nach links über die Oberfläche bewegt, so dass in der Breite der Behandlungsbreite des Plasmastrahls eine Passivierungsspur auf der Metalloberfläche entsteht. Die Passivierungsspur kann dazu genutzt werden, eine Schweißnaht zu passivieren. Die Passivierungsspur kann auch für eine flächige Passivierung einer Metalloberfläche eingesetzt werden, wenn die Plasmaquelle ggf. systematisch über die gesamte zu passivierende Metalloberfläche bewegt wird.

## Patentansprüche

1. Verfahren zum Passivieren einer Metalloberfläche
- bei dem ein atmosphärischer Plasmastrahl durch elektrische Entladung in einem Arbeitsgas erzeugt wird,
- bei dem ein säurehaltiges Passivierungsmittel in den Plasmastrahl eingebracht wird,
- bei dem der das Passivierungsmittel beinhaltende Plasmastrahl auf die Metalloberfläche aufgebracht wird und
- bei dem durch die Reaktion des säurehaltigen Passivierungsmittels mit der Metalloberfläche ein passivierendes Salz auf der Metalloberfläche abgeschieden wird.

2. Verfahren nach Anspruch 1,
bei dem als Passivierungsmittel eine ggf. verdünnte Phosphorsäure eingesetzt wird und Metallphosphat auf der Metalloberfläche abgeschieden wird.

3. Verfahren nach Anspruch 1,
bei dem als Passivierungsmittel eine ggf. verdünnte Chromsäure eingesetzt wird und Metallchromat auf der Metalloberfläche abgeschieden wird.

4. Verfahren nach einem der Ansprüche 1 bis 3,
bei dem die Metalloberfläche eine Schweißnaht aufweist und zumindest die Schweißnaht mit dem Plasmastrahl beaufschlagt wird.

5. Verfahren nach Anspruch 4,
bei dem die Metalloberfläche während des Schweißens oder unmittelbar nach dem Schweißen mit dem Plasmastrahl beaufschlagt wird.

6. Verfahren nach einem der Ansprüche 1 bis 3,
bei dem die Beaufschlagung der Metalloberfläche mit dem Passivierungsmittel zum Erzeugen einer Grundierung für einen anschließenden Farbauftrag oder Lackierung durchgeführt wird.

7. Verfahren nach einem der Ansprüche 1 bis 6,
bei dem das Passivierungsmittel im Entladungsbereich dem entstehenden Plasmastrahl zugeführt wird.

8. Verfahren nach einem der Ansprüche 1 bis 6,
bei dem das Passivierungsmittel strömungsabwärts des Entladungsbereiches dem entstandenen Plasmastrahl zugeführt wird.

9. Verfahren nach Anspruch 7 oder 8,
bei dem das Passivierungsmittel mittels einer Zerstäuberdüse eingebracht wird.

## Claims

1. Method for passivating a metal surface,
- in which an atmospheric plasma beam is generated by electrical discharge in a working gas,
- in which an acid-containing passivating agent is introduced into the plasma beam,
- in which the plasma beam containing the passivating agent is applied to the metal surface, and
- in which a passivating salt is deposited on the metal surface by the reaction between the acid-containing passivating agent and the metal surface.

2. Method according to claim 1, in which an optionally diluted phosphoric acid is used as the passivating agent and metal phosphate is deposited on the metal surface.

3. Method according to claim 1, in which an optionally diluted chromic acid is used as the passivating agent and metal chromate is deposited on the metal surface.

4. Method according to any one of claims 1 to 3, in which the metal surface comprises a weld seam, and the plasma beam is applied at least to the weld seam.

5. Method according to claim 4, in which the plasma beam is applied to the metal surface during or immediately after the welding operation.

6. Method according to any one of claims 1 to 3, in which the passivating agent is applied to the metal surface to create a priming layer for a subsequent application of a coat of paint or varnish.

7. Method according to any one of claims 1 to 6, in which the passivating agent is fed into the developing plasma beam in the discharge area.

8. Method according to any one of claims 1 to 6, in which the passivating agent is fed into the developed plasma beam downstream from the discharge area.

9. Method according to either of claims 7 or 8, in which the passivating agent is introduced via an atomizer nozzle.

## Revendications

1. Procédé de passivation d'une surface métallique
- selon lequel un jet de plasma atmosphérique est généré par décharge électrique dans un gaz de travail,
- selon lequel un agent de passivation contenant de l'acide est introduit dans le jet de plasma,
- selon lequel le jet de plasma qui contient l'agent de passivation est appliqué sur la surface métallique et
- selon lequel un sel passivant est déposé sur la surface métallique par la réaction du jet de plasma qui contient l'agent de passivation avec la surface métallique.

2. Procédé selon la revendication 1,
selon lequel l'agent de passivation utilisé est un acide phosphorique éventuellement dilué et du phosphate métallique est déposé sur la surface métallique.

3. Procédé selon la revendication 1,
selon lequel l'agent de passivation utilisé est un acide chromique éventuellement dilué et du chromate métallique est déposé sur la surface métallique.

4. Procédé selon l'une des revendications 1 à 3,
selon lequel la surface métallique possède un cordon de soudure et au moins le cordon de soudure est exposé au jet de plasma.

5. Procédé selon la revendication 4,
selon lequel la surface métallique est exposée au jet de plasma pendant le soudage ou immédiatement après le soudage.

6. Procédé selon l'une des revendications 1 à 3,
selon lequel la charge de la surface métallique avec l'agent de passivation est effectuée en vue de produire un apprêt pour une application de peinture ou un vernissage qui suit.

7. Procédé selon l'une des revendications 1 à 6,
selon lequel l'agent de passivation est acheminé dans la zone de décharge du jet de plasma produit.

8. Procédé selon l'une des revendications 1 à 6,
selon lequel l'agent de passivation est acheminé en aval de la zone de décharge du jet de plasma produit.

9. Procédé selon la revendication 7 ou 8,
selon lequel l'agent de passivation est incorporé au moyen d'une buse de vaporisateur.
